# EUROPEAN PATENT APPLICATION

(11) **EP 4 068 394 A1**
(43) Date of publication of application: **05.10.2022**
(21) Application number: 20892772.3
(22) Date of filing: 24.11.2020
(51) Int. Cl.: H01L 31/048, E04F 13/08

(54) **SOLAR CELL MODULE, PRODUCTION METHOD FOR SAME, AND BUILDING EXTERNAL WALL MATERIAL USING SAME**

(30) Priority: 25.11.2019 JP 2019212142
(71) Applicant: AGC INC., Chiyoda-ku, Tokyo 1008405 (JP); AGC Glass Europe, 1348 Louvain-La-Neuve (BE)
(72) Inventor: ONOZAKI Yu, Tokyo 100-8405 (JP); SAKAI Tomohiro, Tokyo 100-8405 (JP); SUGAWARA Yasuo, Tokyo 100-8405 (JP); KUWAHARA Yuichi, Tokyo 100-8405 (JP)
(74) Representative: AGC Glass Europe
(86) International application number: PCT/JP2020/043671
(87) International publication number: WO 2021/106872

(57) **Abstract**

To provide a solar cell module excellent in processability at the time of production, a method for producing it, and a building exterior wall material using it.

The method for producing a solar cell module of the present invention is a method for producing a solar cell module, which comprises disposing a cover glass, a first encapsulant material containing a first resin, a design material containing a fluororesin, a second encapsulant material containing a second resin and solar cells in this order, and contact-bonding them with heating to produce a solar cell module comprising, from the light-receiving surface side of the solar cell module, the cover glass, a first encapsulant layer having a thickness of from 50 to 2,000 µm, formed of the first encapsulant material, a design layer having a thickness of from 10 to 1,000 µm, formed of the design material, a second encapsulant layer having a thickness of from 50 to 2,000 µm, formed of the second encapsulant material, and the solar cells in this order, wherein a value obtained by subtracting Tm1 from Tmf, and a value obtained by subtracting Tm2 from Tmf, are both 30°C or higher, where Tmf (°C) is the melting point of the fluororesin, Tm1 (°C) is the melting point of the first resin, and Tm2 (°C) is the melting point of the second resin.

## Description

### TECHNICAL FIELD

The present invention relates to a solar cell module, its production method, and a building exterior wall material using it.

### BACKGROUND ART

Buildings having a solar cell array installed on the rooftop or roof are increasing. When solar cell modules constituting the solar cell array are viewed from the light-receiving surface side, solar cells may be visible in some cases. Specifically, when solar cell modules are installed on wall surfaces, windows or the like of a building, the appearance design of the building may be affected by the visible solar cells in some cases.

Patent Documents 1 to 3 disclose that in order to improve design property which may be impaired by visible solar cells when solar cell modules are viewed from the light-receiving surface side, the side of the visible solar cells is covered with a layer containing nanoparticles, a pigment or the like.

### PRIOR ART DOCUMENTS

### PATENT DOCUMENTS

Patent Document 1: US Patent 8,404,967
Patent Document 2: US Patent 9,276,141
Patent Document 3: WO2018/212988

### DISCLOSURE OF INVENTION

### TECHNICAL PROBLEM

A solar cell module is obtained, for example, by laminating the respective layers constituting the solar cell module and contact-bonding the laminate with heating.

The present inventors have produced solar cell modules having a design layer as disclosed in Patent Documents 1 to 3 and as a result, found that a layer for forming the design layer is deformed or broken at the time of contact-bonding with heating, and the processability at the time of production of the solar cell module should still be improved.

Under these circumstances, the object of the present invention is to provide a solar cell module excellent in processability at the time of production, a method for producing it and a building exterior wall material using it.

### SOLUTION TO PROBLEM

The present inventors have conducted extensive studies on the above object and as a result, found that excellent processability at the time of production is achieved by a method for producing a solar cell module comprising, from the light-receiving surface side of the solar cell module, a cover glass, a first encapsulant layer, a design layer, a second encapsulant layer and solar cells in this order, wherein the thicknesses of the first encapsulant layer, the design layer and the second encapsulant layer are within predetermined ranges, and the melting points or the glass transition temperatures of a first resin contained in the first encapsulant layer and a second resin contained in the second encapsulant layer, and the melting point of a fluororesin contained in the design layer, are in a predetermined relation, and have accomplished the present invention.

That is, the present inventors have found that the above object can be achieved by the following constitutions.
[1] A method for producing a solar cell module, which comprises disposing a cover glass, a first encapsulant material containing a first resin, a design material containing a fluororesin, a second encapsulant material containing a second resin and solar cells in this order, and contact-bonding them with heating to produce a solar cell module,
   wherein the solar cell module comprises, from the light-receiving surface side of the solar cell module,
   the cover glass,
   a first encapsulant layer having a thickness of from 50 to 2,000 µm, formed of the first encapsulant material,
   a design layer having a thickness of from 10 to 1,000 µm, formed of the design material,
   a second encapsulant layer having a thickness of from 50 to 2,000 µm, formed of the second encapsulant material, and
   the solar cells in this order,
   and wherein a value obtained by subtracting Tm1 from Tmf, and a value obtained by subtracting Tm2 from Tmf, are both 30°C or higher, where Tmf (°C) is the melting point of the fluororesin, Tm1 (°C) is the melting point of the first resin, and Tm2 (°C) is the melting point of the second resin.
[2] The method for producing a solar cell module according to [1], wherein at least one of the first resin and the second resin contains at least one member selected from the group consisting of an ethylene/vinyl acetate copolymer and a polyvinyl butyral resin.
[3] The method for producing a solar cell module according to [1] or [2], wherein the fluororesin contains at least one member selected from the group consisting of an ethylene/tetrafluoroethylene copolymer, an ethylene/chlorotrifluoroethylene copolymer, a polychlorotrifluoroethylene, a tetrafluoroethylene/hexafluoropropylene copolymer and a polyvinylidene fluoride.
[4] The method for producing a solar cell module according to any one of [1] to [3], wherein the heating temperature at the time of contact-bonding with heating is Tmf or lower and is higher than Tm1 and Tm2.
[5] The method for producing a solar cell module according to any one of [1] to [4], wherein the solar cells are silicone solar cells constituted by monocrystalline silicon or polycrystalline silicon, or compound solar cells constituted by CIS or CIGS.
[6] The method for producing a solar cell module according to any one of [1] to [5], wherein Tmf is 170°C or higher, and Tm1 and Tm2 are 200°C or lower.
[7] The method for producing a solar cell module according to any one of [1] to [6], wherein the first resin is crosslinked, and the second resin is crosslinked.
[8] The method for producing a solar cell module according to any one of [1] to [7], wherein the thickness of the design layer is from 0.1 to 0.9 times the thickness of the first encapsulant layer, and/or the thickness of the design layer is from 0.1 to 0.9 times the thickness of the second encapsulant layer.
[9] A solar cell module, which comprises, from the light-receiving surface side of the solar cell module, a cover glass, a first encapsulant layer containing a first resin and having a thickness of from 50 to 2,000 µm, a design layer containing a fluororesin and having a thickness of from 10 to 1,000 µm, a second encapsulant layer containing a second resin and having a thickness of from 50 to 2,000 µm, and solar cells in this order,
   wherein a value obtained by subtracting Tm1 from Tmf, and a value obtained by subtracting Tm2 from Tmf, are both 30°C or higher, where Tmf (°C) is the melting point of the fluororesin, Tm1 (°C) is the melting point of the first resin, and Tm2 (°C) is the melting point of the second resin.
[10] The solar cell module according to [9], wherein Tmf is 170°C or higher, and Tm1 and Tm2 are 200°C or lower.
[11] A solar cell module, which comprises, from the light-receiving surface side of the solar cell module, a cover glass, a first encapsulant layer containing a crosslinked product of a first resin and having a thickness of from 50 to 2,000 µm, a design layer containing a fluororesin and having a thickness of from 10 to 1,000 µm, a second encapsulant layer containing a crosslinked product of a second resin and having a thickness of from 50 to 2,000 µm, and solar cells in this order,
   wherein a value obtained by subtracting Tg1 from Tmf, and a value obtained by subtracting Tg2 from Tmf, are both 80°C or higher, where Tmf (°C) is the melting point of the fluororesin, Tg1 (°C) is the glass transition temperature of the crosslinked product of the first resin, and Tg2 (°C) is the glass transition temperature of the crosslinked product of the second resin.
[12] The solar cell module according to [11], wherein Tmf is 170°C or higher, and Tg1 and Tg2 are 120°C or lower.
[13] The solar cell module according to any one of [9] to [12], wherein at least one of the first resin and the second resin contains at least one member selected from the group consisting of an ethylene/vinyl acetate copolymer and a polyvinyl butyral resin.
[14] The solar cell module according to any one of [9] to [13], wherein the fluororesin contains at least one member selected from the group consisting of an ethylene/tetrafluoroethylene copolymer, an ethylene/chlorotrifluoroethylene copolymer, a polychlorotrifluoroethylene, a tetrafluoroethylene/hexafluoropropylene copolymer and a polyvinylidene fluoride.
[15] A building exterior wall material having the solar cell module as defined in any one of [9] to [14].

### ADVANTAGEOUS EFFECTS OF INVENTION

According to the present invention, it is possible to provide a solar cell module excellent in processability at the time of production, a method for producing it, and a building exterior wall material using it.

### BRIEF DESCRIPTION OF DRAWINGS

Fig. 1 is graphs illustrating a sunlight spectrum on the ground and a spectral sensitivity curve of a monocrystalline silicon solar cell.
Fig. 2 is a schematic cross sectional view illustrating an embodiment of a solar cell module obtained by the present production method.
Fig. 3 is a schematic cross sectional view illustrating an embodiment of a solar cell module obtained by the present production method.
Fig. 4 is a schematic plan view illustrating an embodiment a solar cell array constituted by the solar cell modules of the present invention.

### DESCRIPTION OF EMBODIMENTS

Meanings of terms in the present invention are as follows.

" to " used to show the range of numerical values is used to include the numerical values before and after it as the lower limit value and the upper limit value.

A unit generally means an atom group based on one molecule of a monomer directly formed by polymerization of the monomer, and an atom group obtained by chemical conversion of a part of the atom group. The content (mol%) of each of units to all units contained in a polymer is obtained by analysis by nuclear magnetic resonance spectrometry (NMR) of the polymer.

A (meth) acrylate generally means an acrylate and a methacrylate, and (meth)acrylic generally means acrylic and methacrylic.

A hydrolysable silyl group is a group which becomes a silanol group by hydrolysis.

The surface free energy of each material is a value measured in accordance with JIS-K6788. In Examples of this specification, for measurement, Wetting Tension Test Mixture manufactured by Wako Pure Chemical Industries, Ltd. was used.

The melting point of a resin is a temperature at endothermic peak by melting measured by differential scanning calorimetry (DSC).

The glass transition temperature (Tg) of a resin is a midpoint glass transition temperature measured by differential scanning calorimetry (DSC).

The thickness of each layer in the solar cell module is an arithmetic mean value of thicknesses obtained by measuring the thickness of each layer used at the time of production of the solar cell module, by Coolant-Proof Micrometer MDC-25MX manufactured by Mitutoyo Corporation.

The method for producing a solar cell module of the present invention (hereinafter sometimes referred to as the present production method) is a method for producing a solar cell module, which comprises disposing a cover glass, a first encapsulant material containing a first resin, a design material containing a fluororesin, a second encapsulant material containing a second resin and solar cells in this order, and contact-bonding them with heating to produce a solar cell module.

In the present production method, a value obtained by subtracting Tm1 from Tmf, and a value obtained by subtracting Tm2 from Tmf, are both 30°C or higher, where Tmf (°C) is the melting point of the fluororesin, Tm1 (°C) is the melting point of the first resin, and Tm2 (°C) is the melting point of the second resin.

According to the present production method, a solar cell module comprising, from the light-receiving surface side of the solar cell module, a cover glass, a first encapsulant layer having a thickness of from 50 to 2,000 µm, formed of the first encapsulant material, a design layer having a thickness of from 10 to 1,000 µm, formed of the design material, a second encapsulant layer having a thickness of from 50 to 2,000 µm, formed of the second encapsulant material, and solar cells in this order, can be produced.

The present production method is excellent in processability at the time of production of a solar cell module. "Excellent in processability at the time of production of a solar cell module" means that when a solar cell module is produced, deformation and breakage of the design material can be prevented.

The reason why the present production method is excellent in processability at the time of production is not clearly understood, but is estimated as follows.

It is considered that because the melting point of the fluororesin contained in the design material is higher than the melting points of the first resin contained in the first encapsulant material and the second resin contained in the second encapsulant material, even when the first resin and the second resin are molten at the time of contact-bonding with heating, the design material will be stably disposed between the first encapsulant material and the second encapsulant material. Further, deformation of the design material by a stress accompanying flow of the first encapsulant material and the second encapsulant material at the time of contact-bonding with heating can be prevented. Further, so long as the thicknesses of the first encapsulant layer, the design layer and the second encapsulant layer after contact-bonding with heating are within predetermined ranges, it is possible to suppress deformation of the design material in the laminate and formation of wrinkles in the design material at the time of contact-bonding with heating. It is estimated that such effects synergistically function to suppress deformation and breakage of the design material at the time of production of a solar cell module.

In the present production method, it is preferred to dispose a cover glass, a first encapsulant material, a design material, a second encapsulant material and solar cells in this order to obtain a laminate, followed by contact-bonding with heating. Otherwise, some of these materials may preliminarily be laminated and contact-bonded with heating, and then the rest of the materials are laminated and contact-bonded with heating.

As the cover glass, a glass plate may be mentioned. As specific examples of the material constituting the glass plate, soda lime silicate glass, quartz glass, crystal glass, alkali-free glass, aluminosilicate glass, borosilicate glass and barium borosilicate glass may be mentioned, and in view of high transparency, soda lime silicate glass is preferred.

As a specific example of soda lime silicate glass, glass having a composition comprising, based on oxides, from 60 to 75 mass% of SiO₂, from 0 to 3 mass% of Al₂O₃, from 0 to 15 mass% of CaO, from 0 to 12 mass% of MgO and from 5 to 20 mass% of Na₂O may be mentioned. Here, SiO₂ is the main component of soda lime silicate glass.

Soda lime silicate glass may further contain, in addition to the above components, at least one component selected from the group consisting of K₂O, TiO₂, ZrO₂ and LiO₂.

Further, soda lime silicate glass may further contain a clarifying agent (such as SO₃, SnO₂ or Sb₂O₃).

The cover glass may be a tempered glass plate having tempering treatment applied thereto. A tempered glass plate is preferred since it is hardly broken as compared with a cover glass having no tempering treatment applied thereto. As a tempered glass plate, for example, a glass plate having a front layer having residual compressive stress, a rear layer having residual compressive stress, and an interlayer having residual tensile stress formed between the front layer and the rear layer, is used.

As specific examples of the tempering treatment, chemical tempering treatment carried out e.g. by known ion exchange method and physical tempering treatment carried out e.g. by known air-cooling tempering method may be mentioned. A chemically tempered glass plate has sufficient strength even if it is thin, since the front layer or the rear layer has large residual compressive stress.

The cover glass may be surface-treated in view of adhesion to the first encapsulant material. The surface treatment method may be a known method, such as activation treatment (e.g. plasma method, deposition method, acid treatment or base treatment), chemical conversion, polishing of the material surface, sander treatment, sealing treatment, blasting treatment or primer treatment.

As specific examples of the primer agent, a silane coupling agent (particularly an alkoxysilane or the like), an epoxy resin, a (meth)acrylic resin and a polyester resin may be mentioned.

The cover glass preferably contains, as represented by mass percentage based on oxides, 0.3 mass% or less of Fe₂O₃, more preferably 0.1 mass% or less, particularly preferably 0.03 mass% or less. When the content of Fe₂O₃ is 0.3 mass% or less, absorption of near infrared light by Fe₂O₃ can be suppressed, whereby the power generation efficiency will improve. Accordingly, a cover glass having a Fe₂O₃ content of 0.3 mass% or less is suitable for a solar cell module having solar cells having high spectral sensitivity to near infrared light.

The Fe₂O₃ content in this specification means a content obtained by converting the content of total iron contained in the cover glass into Fe₂O₃, which is obtained by fluorescent X-ray measurement.

The thickness of the cover glass is optionally set depending upon e.g. the designed wind pressure of a building. The thickness of the cover glass is preferably from 1 to 30 mm, more preferably from 3 to 20 mm, particularly preferably from 3 to 15 mm. When the thickness is 1 mm or more, high durability will be achieved, and the cover glass will be hardly broken. When the thickness is 30 mm or less, the present cover glass is light in weight, and the present solar cell module is more suitably used for the wall surface or windows of a building.

The thickness of the cover glass is an arithmetic mean value of the thicknesses obtained by measuring the thickness of the cover glass by a thickness meter.

The first encapsulant material is a material containing a first resin and forming the first encapsulant layer in the solar cell module by contact-bonding with heating. The first resin may or may not be crosslinked. The resin in the first encapsulant layer is preferably crosslinked.

Likewise, the second encapsulant material is a material containing a second resin and forming the second encapsulant layer in the solar cell module by contact-bonding with heating. The second resin may or may not be crosslinked. The resin in the second encapsulant layer is preferably crosslinked. The first encapsulant material and the second encapsulant material may be the same or different.

Hereinafter, points common in the first encapsulant material and the second encapsulant material will generally be described. For explanation, the first encapsulant material and the second encapsulant material may sometimes be generally referred to as an encapsulant material, and the first resin and the second resin may sometimes be generally referred to as an encapsulant resin. Further, the first encapsulant layer and the second encapsulant layer may sometimes be generally referred to as an encapsulant layer.

The encapsulant material contains the encapsulant resin. The encapsulant resin is preferably at least one resin selected from the group consisting of an olefin resin (particularly an ethylene/vinyl acetate copolymer (EVA resin)), a polyvinyl butyral resin (PVB resin), an ionomer resin and a silicone resin, and in view of adhesion to the cover glass and the design layer, durability and transparency, particularly preferably at least one resin selected from the group consisting of an ethylene/vinyl acetate copolymer and a polyvinyl butyral resin.

The melting point of the encapsulant resin is preferably 200°C or lower, more preferably from 40 to 200°C, further preferably from 50 to 170°C, particularly preferably from 60 to 150°C, in view of processability at the time of production of the solar cell module, and handling efficiency and storage stability of the encapsulant material.

The encapsulant resin may be used in combination of two or more.

The content of the encapsulant resin in the encapsulant material is, to the total mass of the encapsulant material, preferably 50 mass% or more, more preferably 70 mass% or more, particularly preferably 90 mass% or more, in view of more excellent processability at the time of production of the solar cell module. The upper limit value of the resin content in the encapsulant material is usually 99.99 mass%.

The encapsulant material may or may not contain an ultraviolet absorber, a crosslinking agent, or the like. The encapsulant material preferably contains an ultraviolet absorber, a crosslinking agent, or the like, in view of durability of the encapsulant layer. Further, the encapsulant material may contain components such as inorganic particles described hereinafter.

The ultraviolet absorber is preferably e.g. a salicylic acid ester-based, benzotriazole-based, benzophenone-based, cyanoacrylate-based or triazine-based ultraviolet absorber.

As specific examples of the ultraviolet absorber, "Tinuvin 326", "Tinuvin 400", "Tinuvin 405", "Tinuvin 460", "Tinuvin 900" and "Tinuvin 928" manufactured by BASF, "Sanduvor VSU powder" manufactured by Clariant and "Hastavin PR-25 Gran" manufactured by Clariant may be mentioned. The ultraviolet absorber may be used in combination of two or more.

The ultraviolet absorber is particularly preferably contained in the first encapsulant material. The first encapsulant material forms the first encapsulant layer disposed closer to the sunlight-receiving surface side than the design layer in the solar cell module. Accordingly, when the first encapsulant material contains the ultraviolet absorber, the resulting solar cell module will be more excellent in weather resistance of the design layer.

The content of the ultraviolet absorber is, in view of more excellent weather resistance of the solar cell module, to the total mass of the first encapsulant layer, preferably from 0.01 to 5 mass%, particularly preferably from 0.2 to 3 mass%.

As the crosslinking agent, a known crosslinking agent such as an organic peroxide may be mentioned. The crosslinking agent may be used in combination of two or more.

The thickness of the encapsulant material is the thickness of the encapsulant layer in the solar cell module, or less.

The thickness of the encapsulant material is from 50 to 2,000 µm, preferably from 100 to 1,500 µm, particularly preferably from 200 to 1,000 µm. When the thickness of the encapsulant material is 50 µm or more, excellent processability at the time of production of the solar cell module will be achieved.

In the solar cell module, a strong stress applied to the bonding interface generated by the difference in thermal expansion between layers, is likely to cause separation of the layers. When the thickness of the encapsulant material is 50 µm or more, this stress can be reduced, and excellent durability will be achieved. When the thickness of the encapsulant material is 2,000 µm or less, such is economically advantageous, and deformation of the encapsulant layer is suppressed, whereby excellent fastness property as a building material will be achieved.

The encapsulant material may consist of a single material or may be a laminate of two or more materials. In a case where the encapsulant material is a laminate of two or more materials, the composition, the thickness, etc. of the respective layers may be the same or different. In a case where the encapsulant material is a laminate of two or more materials, the thickness of the encapsulant material is the sum of the thicknesses of the layers constituting the encapsulant material.

The encapsulant material is, when laminated, preferably in a film form or in a sheet form.

The design material is a material forming a design layer in the solar cell module by contact-bonding with heating.

The design material contains a fluororesin which is solid at room temperature (23°C). The fluororesin is preferably a fluorinated polymer containing units having a fluorine atom (hereinafter sometimes referred to as units F).

The fluorinated polymer preferably contains as the units F units based on a fluoroolefin (hereinafter sometimes referred to as units F1).

A fluoroolefin is an olefin having one or more hydrogen atoms replaced with a fluorine atom. The fluoroolefin may have one or more hydrogen atoms not replaced with a fluorine atom replaced with a chlorine atom. The number of carbon atoms in the fluoroolefin is preferably from 2 to 8, more preferably from 2 to 6, particularly preferably from 2 to 4.

As specific examples of the fluoroolefin, monomers such as CF₂=CF₂ (TFE), CF₂=CFCl (CTFE), CF₂=CHF, CH₂=CF₂ (VDF), CF₂=CFCF₃ (HFP), CF₂=CHCF₃, CF₃CH=CHF, CF₃CF=CH₂, CH₂=CHCF₂CF₃, and CH₂=CHCF₂CF₂CF₂CF₃ (PFBE) may be mentioned. As the fluoroolefin, in view of more excellent weather resistance of the present solar cell module, TFE, CTFE, VDF, HFP, PFBE and the like are preferred. The fluoroolefin may be used in combination of two or more.

The content of the units F1 is, to all units contained in the fluorinated polymer, in view of weather resistance of the present solar cell module, preferably from 20 to 100 mol%, more preferably from 30 to 100 mol%, particularly preferably from 40 to 60 mol%.

The fluorinated polymer may contain only the units F1 or may further contain, as the units F, units based on a monomer containing a fluorine atom other than the fluoroolefin (hereinafter sometimes referred to as monomer F2) (hereinafter sometimes referred to as units F2), or may contain units based on a monomer containing no fluorine atom (hereinafter sometimes referred to as monomer D) (hereinafter sometimes referred to as units D), or the like.

As the monomer F2, a fluorovinyl ether, a monomer having an alicyclic or aliphatic heterocyclic structure containing a fluorine atom, or a fluoroalkyl (meth)acrylate may, for example, be mentioned, and a fluorovinyl ether is preferred.

As specific examples of the fluorovinyl ether, CF₂=CFOCF₃, CF₂=CFOCF₂CF₃, CF2=CFO(CF2)2CF3 (PPVE), CF₂=CFOCF₂CF(CF₃)O(CF₂)₂CF₃, CF₂=CFO(CF₂)₃O(CF₂)₂CF₃, CF₂=CFO(CF₂CF(CF₃)O)₂(CF₂)₂CF₃, CF₂=CFOCF₂CF(CF₃)O(CF₂)₂CF₃, CF₂=CFOCF₂CF=CF₂, and CF₂=CFO(CF₂)₂CF=CF₂ may be mentioned. The fluorovinyl ether may have a functional group such as -SO₂F or -CO₂CH₃.

As specific examples of the monomer having an alicyclic or aliphatic heterocyclic structure containing a fluorine atom, perfluoro(2,2-dimethyl-1,3-dioxole), 2,2,4-trifluoro-5-trifluoromethoxy-1,3-dioxole, and perfluoro(2-methylene-4-methyl-1,3-dioxolane) may be mentioned.

As the monomer D, an olefin, a vinyl ether, a vinyl carboxylate, an allyl ether, a (meth)acrylic acid ester, a carboxylic acid having a polymerizable unsaturated group and an unsaturated acid anhydride may, for example, be mentioned. The monomer D may have a functional group. As the functional group, a hydroxy group, a carboxy group, an amino group and a hydrolysable silyl group may be mentioned, and in view of further improvement of the strength of the design layer, a hydroxy group or a carboxy group is more preferred.

The olefin may, for example, be ethylene, propylene or isobutene, and is preferably ethylene.

The vinyl ether may, for example, be ethyl vinyl ether, tert-butyl vinyl ether, 2-ethylhexyl vinyl ether, cyclohexyl vinyl ether, 2-hydroxyethyl vinyl ether or 4-hydroxybutyl vinyl ether.

The vinyl carboxylate may, for example, be vinyl acetate, vinyl pivalate, vinyl neononanoate, vinyl neodecanoate, vinyl benzoate, vinyl tert-butyl benzoate or vinyl versatate, and is preferably vinyl acetate.

The allyl ether may, for example, be 2-hydroxyethyl allyl ether.

The (meth)acrylic acid ester may, for example, be tert-butyl (meth)acrylate, benzyl (meth)acrylate or 2-hydroxyethyl (meth)acrylate.

The carboxylic acid having a polymerizable unsaturated group may, for example, be undecylenic acid or crotonic acid.

The unsaturated acid anhydride may, for example, be maleic anhydride, itaconic anhydride, citraconic anhydride or himic anhydride (such as 5-norbornene-2,3-dicarboxylic anhydride).

The monomer D is preferably ethylene or the vinyl ether in view of processability at the time of production of the present solar cell module.

The monomer D may be used in combination of two or more.

When the fluorinated polymer contains the units D, the content of the units D to all units contained in the fluorinated polymer is preferably more than 0 mol% and 80 mol% or less, more preferably more than 0 mol% and 70 mol% or less, particularly preferably from 40 to 60 mol%.

As the fluorinated polymer containing only the units F1, a homopolymer of the fluoroolefin or a copolymer of two or more types of the fluoroolefins may be mentioned. As the fluorinated polymer containing only the units F1, specifically, a polytetrafluoroethylene, a polychlorotrifluoroethylene (PCTFE), a tetrafluoroethylene/hexafluoropropylene copolymer (FEP) and a polyvinylidene fluoride (PVDF) may be mentioned, and in view of processability at the time of production of the present solar cell module, PCTFE, FEP or PVDF is preferred, and PCTFE or FEP is particularly preferred.

As the fluorinated polymer containing the units F1 and the units D, an ethylene/tetrafluoroethylene copolymer (ETFE), an ethylene/chlorotrifluoroethylene copolymer (ECTFE), a chlorotrifluoroethylene/vinyl ether copolymer (FEVE) or a tetrafluoroethylene/vinyl carboxylate copolymer (FEVEs) may, for example, be mentioned, and in view of processability at the time of production of the present solar cell module, ETFE, ECTFE or FEVE is preferred.

ETFE preferably contains TFE units and ethylene units, in a molar ratio of the TFE units to the ethylene units (TFE units/ethylene units) of from 40/60 to 60/40. ETFE may contain units other than the TFE units and the ethylene units, and the content of such units if contained is preferably from 0.5 to 10 mol% to all units contained in ETFE. As the units other than the TFE units and the ethylene units, HFP units, PFBE units, PPVE units, etc. are preferred.

The melting point (Tmf) of the fluororesin is, in view of more excellent processability at the time of production of the solar cell module, preferably 170°C or higher, more preferably 190°C or higher, particularly preferably 200°C or higher. The upper limit value of Tmf is not particularly limited.

The design material may contain two or more types of the fluororesins.

The content of the fluororesin in the design material is, in view of weather resistance of the present solar cell module, to the total mass of the design layer, preferably from 5 to 100 mass%, particularly preferably from 10 to 90 mass%.

The design material preferably contains inorganic particles, whereby high design property can be imparted while weather resistance of the present solar cell module is maintained.

As specific examples of the inorganic particles, particles of a composite oxide containing two or more types of metal atoms selected from the group consisting of chromium, titanium, antimony, iron, aluminum, nickel, barium, lead, vanadium, bismuth, zinc, cobalt and manganese may be mentioned. More specifically, particles of a composite oxide (orange) of chromium, titanium and antimony, a composite oxide (orange) of iron, aluminum and titanium, a composite oxide (yellow) of nickel, titanium and antimony, a composite oxide of titanium, nickel and barium, a composite oxide (yellow) of chromium and lead, a composite oxide (yellow) of vanadium and bismuth, a composite oxide (green) of nickel, cobalt, zinc and titanium, a composite oxide (green) of cobalt, zinc and titanium, a composite oxide (brown) of zinc, nickel and titanium, a composite oxide (brown) of manganese, antimony and titanium, a composite oxide (blue) of aluminum and cobalt, and a composite oxide (black) of cobalt, iron and chromium may, for example, be mentioned.

As specific examples of the inorganic particles other than the metal composite oxide particles, particles of silicon oxide, titanium oxide (white), zirconium oxide (white), iron oxide (red) and cobalt lithium phosphate (purple) may be mentioned.

As the inorganic particles, in view of design property of the solar cell module, among the above inorganic particles, colored inorganic particles (inorganic pigment) with specific color described are preferred.

When the design material contains inorganic particles, the content of the inorganic particles is, with a view to concealing the solar cells and in view of balance between the strength and flexibility of the design layer, per 100 parts by mass of the fluororesin, preferably from 1 to 100 parts by mass, more preferably from 3 to 60 parts by mass, particularly preferably from 10 to 50 parts by mass.

The shape of the inorganic particles is not particularly limited, and the particles may be in any shape of spheres, ellipses, needles, plates, rods, cones, columns, cubes, cuboids, diamonds, stars, scales, irregular particles, and the like. Further, the inorganic particles may be hollow particles or may be solid particles. Further, the inorganic particles may be porous particles.

The design material may contain two or more types of the inorganic particles.

The design material may contain a non-fluororesin. The non-fluororesin is a resin containing no fluorine atom, which is solid at room temperature (23°C). As specific examples of the non-fluororesin, an alkyd resin, an aminoalkyd resin, a polyester resin, an epoxy resin, a urethane resin, an epoxypolyester resin, a vinyl acetate resin, an acrylic resin, a vinyl chloride resin, a phenol resin, a modified polyester resin, an acrylic silicone resin and a silicone resin may be mentioned.

The design material may contain, as the case requires, components other than the above. Such components may, for example, be a curing catalyst, an organic filler, an organic pigment (such as copper phthalocyanine (blue, green) or perylene (red)), a photo stabilizer, an ultraviolet absorber, a delustering agent, a leveling agent, a degassing agent, a filler, a thermal stabilizer, a thickener, a dispersing agent, a surfactant, an antistatic agent, a delustering agent, a silane coupling agent, an antifouling agent and a contamination-reducing agent.

The thickness of the design layer is, with a view to preventing deformation at the time of lamination, preferably from 10 to 1,000 µm, more preferably from 20 to 800 µm, particularly preferably from 40 to 500 µm.

The design material may consist of a single material or may be a laminate of two or more materials. In a case where the design material is a laminate of two or more materials, the composition, the thickness, etc. of the respective layers may be the same ore different. In a case where the design material is a laminate of two or more materials, the thickness of the design material is the sum of the thicknesses of the layers constituting the design material.

As a specific example of a method for producing the design material, a method of kneading the fluororesin and inorganic particles, etc., used as the case requires by a kneading machine, and drawing the kneaded product e.g. by a hot roll pressing machine to obtain a film or a sheet, may be mentioned. In such a case, the design material is in the form of a film (a sheet) when laminated. Further, the design material may be produced by applying a composition containing the fluororesin to the first encapsulant material or the second encapsulant material.

To the design material, with a view to adjusting the surface free energy to improve adhesion to the first encapsulant layer and the second encapsulant layer, plasma treatment, corona discharge treatment, surface treatment by high-frequency sputtering, RF bombardment treatment, DC bombardment treatment, glow discharge treatment or the like may be applied.

A value obtained by subtracting the melting point (Tm1) of the first resin from the melting point (Tmf) of the fluororesin, that is (Tmf-Tm1), and a value obtained by subtracting the melting point (Tm2) of the second resin from the melting point (Tmf) of the fluororesin, that is (Tmf-Tm2) are both 30°C or higher, and in view of more excellent processability at the time of production of the solar cell module, preferably 40°C or higher, more preferably 50°C or higher.

The upper limit values of Tmf-Tm1 and Tmf-Tm2 are not particularly limited, and in view of more excellent handling efficiency of the first resin and the second resin, preferably 300°C or lower, more preferably 250°C or lower, further preferably 230°C or lower.

The total thickness of the first encapsulant material, the design material and the second encapsulant material is preferably from 150 to 3,000 µm, more preferably from 300 to 1,500 µm, in view of distortion and durability. The design material is preferably thinner than the first encapsulant material, specifically, the thickness of the design material is preferably from 0.1 to 0.9 times the thickness of the first encapsulant material, in view of distortion and processability. Likewise, the design layer is preferably thinner than the second encapsulant material, specifically, the thickness of the design layer is preferably from 0.1 to 0.9 times the thickness of the second encapsulant layer in view of distortion and processability. When the thickness of the design material is 0.1 times or more the thickness of the first encapsulant material, excellent appearance after processing will be achieved. When the thickness of the design material is 0.9 times or less the thickness of the first encapsulant material, the design material can readily be cut in accordance with the shape of the solar cell module, thus leading to excellent processability.

Each solar cell has a function to convert light energy received by the light-receiving surface of the solar cell to electric energy. Each solar cell may have this function only on one light-receiving surface, or may have this function on the other light-receiving surface too.

As the solar cell, known solar cells such as a silicon solar cell constituted by e.g. monocrystalline silicon or polycrystalline silicon, an amorphous silicon solar cell, a compound solar cell constituted by GaAs, CIS, CIGS, CdTe, InP, Zn₃P₂ or Cu₂S (preferably CIS of CIGS), and a perovskite solar cell may be used.

The solar cell is preferably made of a material having spectral sensitivity in near infrared region, whereby both design property and the power generation efficiency can readily be satisfied. Specifically, a silicon solar cell constituted by e.g. monocrystalline silicon or polycrystalline silicon, or a compound solar cell constituted by GaAs, CIS, CIGS, CdTe, InP, Zn₃P₂ or Cu₂S (preferably CIS or CIGS) may be mentioned, and in view of more excellent power generation in near infrared region, a monocrystalline silicon solar cell, a CIS solar cell or a CIGS solar cell is particularly preferred. Further, a CIS solar cell or a CIGS solar cell is particularly preferred in that the present solar cell module will be more excellent in design property and can suitably be used as an exterior wall material, since no wiring is required. Further, in a case where the solar cell has wiring, in view of design property of the present solar cell module, the wiring is preferably colored, particularly preferably colored black.

The peak of the spectral sensitivity of the solar cell is present preferably at a wavelength within a range of from 780 to 1,200 nm, particularly preferably from 780 to 1,000 nm.

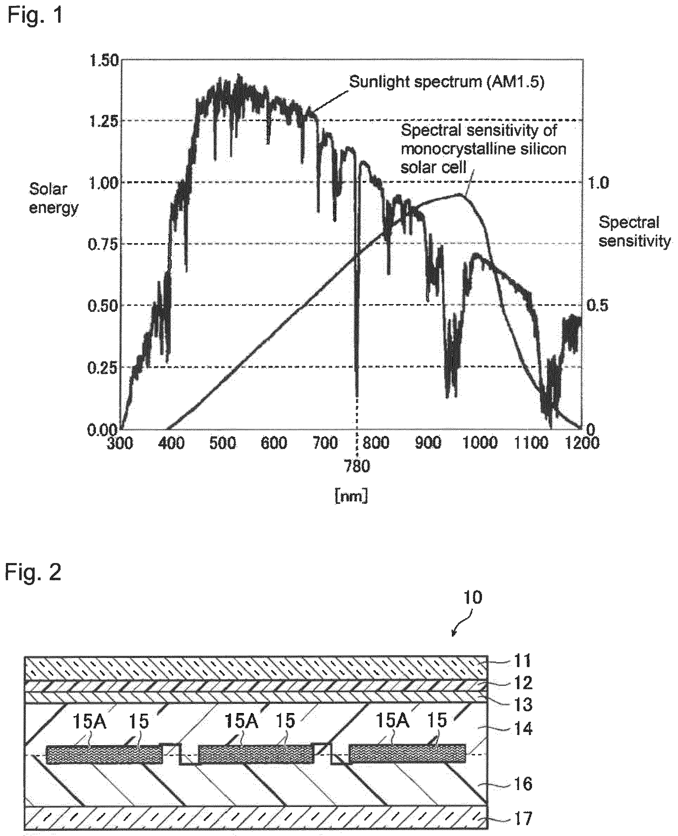

Fig. 1 is graphs illustrating a sunlight spectrum (solar energy) on the ground and a spectral sensitivity curve of a monocrystalline silicon solar cell.

As shown in Fig. 1, a monocrystalline silicon solar cell has high spectral sensitivity also to light in a wavelength region longer than 780 nm. Accordingly, it can exhibit design property by scattering light in the visible region and exhibit favorable power generation efficiency by transmitting near infrared light. That is, by using a cover glass showing a high transmittance in a long wavelength region, a solar cell module which may have both design property and power generation efficiency can be obtained.

In the present production method, in the laminate, materials other than the above may be disposed between the materials or outside the laminate.

In the present production method, for example, a laminate further having a third encapsulant material on the side opposite of the solar cells from the second encapsulant material, may be used. In such a case, a laminate having a cover glass, a first encapsulant material, a design material, a second encapsulant material, solar cells and a third encapsulant material disposed in this order may be used.

The third encapsulant material contains a third resin and forms a third encapsulant layer which may be contained in the solar cell module by contact-bonding with heating. Specific examples and preferred embodiments of the third encapsulant material and the third resin are the same as those of the above encapsulant material and encapsulant resin. The third encapsulant material and the third resin may be the same as or different from the other encapsulant material and encapsulant resin.

In the present production method, for example, a laminate further having a back glass or a back sheet on the side opposite of solar cells from the second encapsulant material may be used. A laminate further having, in addition to the back glass or the back sheet, the third encapsulant material may be used. In such a case, for example, a laminate having a cover glass, a first encapsulant material, a design material, a second encapsulant material, solar cells, a third encapsulant material and a back glass or a back sheet disposed in this order may be used.

Preferred embodiments of the back glass are the same as those of the cover glass.

The back sheet contains a resin. The resin in the back sheet may, for example, be polyvinyl fluoride, polyvinylidene fluoride, a tetrafluoroethylene/hexafluoropropylene copolymer or a polyethylene terephthalate copolymer.

In the example in Fig. 1, an embodiment is shown in which the back glass 17 is used, however, a back sheet may be used instead of the back glass.

In the present production method, it is preferred to use the back glass, whereby the resulting solar cell module has excellent fastness property and durability as a building material.

The back glass or the back sheet may be black, or may further have a black colored layer (black layer), whereby it is possible to suppress entrance of light transmitted through the solar cells into the solar cells from the side opposite from the first encapsulant layer. As a result, weather resistance of the solar cell module will more improve.

The black layer has a black appearance, and specifically, contains a black coloring agent with L^{*} value of preferably from 0 to 40, more preferably from 0 to 20, particularly preferably from 0 to 10.

In the above description, an embodiment is shown in which the cover glass, the first encapsulant material, the design material and the second encapsulant material are laminated only on one side of solar cells, however, the present production method is not limited thereto.

For example, in the present production method, the same constitution as that on one side of solar cells may be provided on the other side of the solar cells.

Contact-bonding with heating may be conducted, for example, be a hot contact-bonding apparatus or a vacuum hot contact-bonding apparatus.

The heating temperature in contact-bonding with heating is, in view of more excellent processability at the time of production of the solar cell module, preferably Tmf or less (preferably less than Tmf), and higher than Tm1 and Tm2.

The heating temperature in contact-bonding with heating is preferably from 120 to 200°C, more preferably from 130 to 180°C, particularly preferably from 140 to 165°C.

In the present production method, by contact-bonding the laminate with heating, a solar cell module comprising, from the light-receiving surface side of the solar cell module, the cover glass, the first encapsulant layer, the design layer, the second encapsulant layer and solar cells in this order, can be obtained.

Fig. 2 is a schematic cross sectional view illustrating an embodiment of a solar cell module obtained by the present production method. As shown in Fig. 2, the solar cell module 10 has, from the light-receiving surface side of the solar cell module 10, a cover glass 11, a first encapsulant layer 12, a design layer 13, a second encapsulant layer 14, a plurality of solar cells 15, a third encapsulant layer 16, and a back glass 17, in this order. All the solar cells 15 are encapsulated by the second encapsulant layer 14 and the third encapsulant layer 16.

The cover glass and the solar cells in the solar cell module obtained by the present production method are the same as the cover glass and the solar cells used in the present production method.

The first encapsulant layer is a layer containing the above first resin or containing a crosslinked product of the first resin, and corresponding to the first encapsulant material in the laminate. Accordingly, the components contained in the first encapsulant layer and their contents are the same as those of the first encapsulant material.

The range of the thickness and preferred embodiments of the first encapsulant layer are the same as the range of the thickness and preferred embodiments of the encapsulant material.

In a case where the first encapsulant layer contains a crosslinked product of the first resin, the glass transition temperature of the crosslinked product of the first resin is, in view of processability at the time of production of the solar cell module, and handling efficiency and storage stability of the first encapsulant material, preferably 120°C or lower, more preferably from -40 to 100°C, particularly preferably from -35 to 80°C.

The first encapsulant layer is, with a view to protecting the after-described design layer from ultraviolet rays, disposed on the side closer to the sunlight-receiving surface side than the design layer, and in view of adhesion to the design layer and the cover glass, it is preferably laminated so that one side of the first encapsulant layer is in contact with the design layer and the other side is in contact with the cover glass.

The design layer is a layer containing the above fluororesin and corresponding to the design material in the laminate.

The design layer can conceal the solar cells and improve design property of the solar cell module. The design layer is preferably colored. The design layer being colored specifically means that the average visible reflectance of the design layer, which is an arithmetic mean of reflectances at 5 nm intervals in a visible region at a wavelength of from 380 to 780 nm, is 10% or more. When the average visible reflectance of the design layer is 10% or more, the incident light is reflected and scattered on the design layer and the resulting reflected/scattered light is visible, and thus the design layer is recognized as colored. The average visible reflectance of the design layer may optionally be changed depending upon the color tone required.

The design layer may be uniformly colored, or may be partially colored to form a pattern, and in view of power generation efficiency of the solar cell module, it is preferably uniformly colored.

The content of the fluororesin in the design layer is preferably the same as the content of the fluororesin contained in the design material.

Components other than the fluororesin in the design layer and their contents are the same as those of the design material.

The range of the thickness and preferred embodiments of the design layer are the same as the range of the thickness and the preferred embodiments of the design material.

The second encapsulant layer is a layer containing the above second resin or containing a crosslinked product of the second resin, and corresponding to the second encapsulant material in the laminate. Accordingly, the components contained in the second encapsulant layer and their contents are the same as those of the second encapsulant material.

The range of the thickness and preferred embodiments of the second encapsulant layer are the same as the range of the thickness and preferred embodiments of the encapsulant material.

In a case where the second encapsulant layer contains a crosslinked product of the second resin, the glass transition temperature of the crosslinked product of the second resin is, in view of processability at the time of production of the solar cell module, and handling efficiency and storage stability of the second encapsulant material, preferably 120°C or lower, more preferably from -40 to 100°C, particularly preferably from -35 to 80°C.

The second encapsulant layer is disposed on the side closer to the solar cell side than the design layer, so as to encapsulate the solar cells, and in view of adhesion to the design layer and the solar cells, it is preferably laminated so that one side of the second encapsulant layer is in contact with the design layer and the other side is in contact with the solar cells. Particularly, the present inventors have found that since the design layer of the present invention contains a fluororesin, adhesion between layers may sometimes be problematic. By the presence of the design layer between the first encapsulant layer and the second encapsulant layer, adhesion between layers in the solar cell module will remarkably be improved.

In a case where a laminate having the third encapsulant material is used, the solar cell module obtained by the present production method contains the third encapsulant layer.

The third encapsulant layer is a layer containing the third resin or containing a crosslinked product of the first resin and corresponding to the third encapsulant material in the laminate. Accordingly, the components contained in the third encapsulant layer and their contents are the same as those of the third encapsulant material.

The range of the thickness and preferred embodiments of the third encapsulant layer are the same as the range of the thickness and the preferred embodiments of the encapsulant material.

The third encapsulant layer is laminated preferably to be in contact with the solar cells, so as to encapsulate the solar cells together with the second encapsulant layer.

In a case where a laminate having a back glass is used, the solar cell module obtained by the present production method contains the back glass. In such a case, the back glass contained in the solar cell module is the same as the back glass in the laminate.

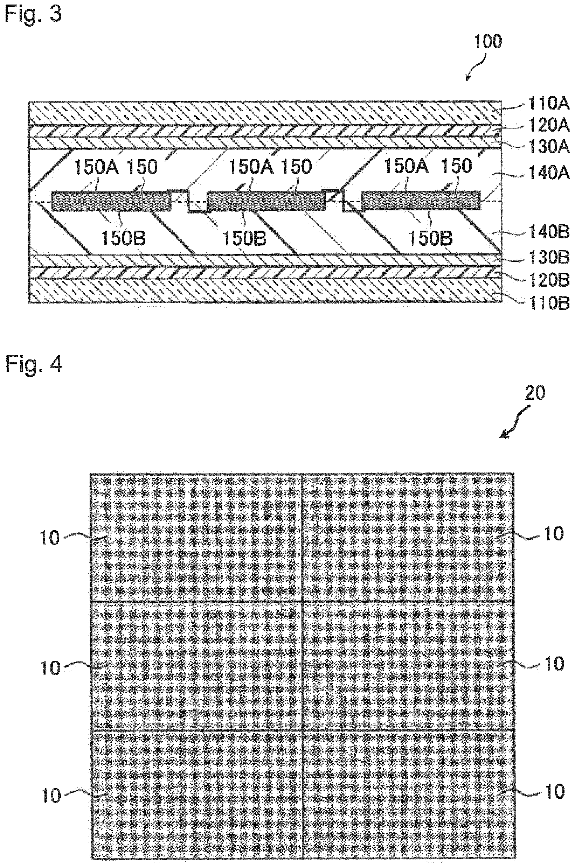

Further, in a case where a laminate having the same layer constitution as that on one side of solar cells on the other side is used, a solar cell module having the above constitution on both sides of the solar cells is obtained, as shown in Fig. 3.

Fig. 3 is a schematic cross sectional view illustrating another embodiment of a solar cell module obtained by the present production method.

As shown in Fig. 3, the solar cell module 100 has a plurality of solar cells 150, and has, on the first light-receiving surface 150A side of the solar cells 150, a second encapsulant layer 140A, a design layer 130A, a first encapsulant layer 120A and a cover glass 110A in this order, and has, on the second light-receiving surface 150B side of the solar cells 150, a second encapsulant layer 140B, a design layer 130B, a first encapsulant layer 120B and a cover glass 110B in this order.

The cover glass 110A, the first encapsulant layer 120A, the design layer 130A, the second encapsulant layer 140A and the solar cells 150 are respectively the same as the cover glass 11, the first encapsulant layer 12, the design layer 13, the second encapsulant layer 14 and the solar cells 15 in Fig. 2, and their descriptions are omitted.

The cover glass 110B, the first encapsulant layer 120B, the design layer 130B and the second encapsulant layer 140B are respectively the same as the cover glass 11, the first encapsulant layer 12, the design layer 13 and the second encapsulant layer 14 in Fig. 2, and their descriptions are omitted.

The solar cell module 100 may suitably be used in a case where the sunlight enters from both sides, for example, for a fence.

The solar cell module according to one embodiment of the present invention, comprises, from the light-receiving surface side of the solar cell module, a cover glass, a first encapsulant layer containing a first resin and having a thickness of from 50 to 2,000 µm, a design layer containing a fluororesin and having a thickness of from 10 to 1,000 µm, a second encapsulant layer containing a second resin and having a thickness of from 50 to 2,000 µm, and solar cells, in this order.

Further, in the solar cell module of the present invention, a value obtained by subtracting Tm1 from Tmf and a value obtained by subtracting Tm2 from Tmf, are both 30°C or higher, preferably 40°C or higher, particularly preferably 50°C or higher, where Tmf (°C) is the melting point of the fluororesin, Tm1 (°C) is the melting point of the first resin, and Tm2 (°C) is the melting point of the second resin.

Further, in view of good processability and excellent appearance after processing, it is preferred that Tmf is 170°C or higher, and Tm1 and Tm2 are 200°C or lower.

The solar cell module of the present invention is preferably a solar cell module obtained by the above method for producing a solar cell module.

The constitution of the solar cell module of the present invention is the same as the constitution of the solar cell module obtained by the above method for producing a solar cell module, and its description is omitted.

The solar cell module according to one embodiment of the present invention comprises, from the light-receiving surface side of the solar cell module, a cover glass, a first encapsulant layer containing a crosslinked product of a first resin and having a thickness of from 50 to 2,000 µm, a design layer containing a fluororesin and having a thickness of from 10 to 1,000 µm, a second encapsulant layer containing a crosslinked product of a second resin and having a thickness of from 50 to 2,000 µm, and solar cells, in this order.

The total thickness of the first encapsulant layer, the design layer and the second encapsulant layer is preferably from 150 to 3,000 µm, more preferably from 300 to 1,500 µm, in view of distortion and durability. Further, the design layer is preferably thinner than the first encapsulant layer, specifically, the thickness of the design layer is preferably from 0.1 to 0.9 times the thickness of the first encapsulant layer in view of distortion and processability. Likewise, the design layer is preferably thinner than the second encapsulant layer, specifically, the thickness of the design layer is from 0.1 to 0.9 times the thickness of the second encapsulant layer in view of distortion and processability. When the thickness of the design layer is 0.1 times or more the thickness of the first encapsulant layer, excellent appearance after processing will be achieved. When the thickness of the design layer is 0.9 times or less the thickness of the first encapsulant layer, the design layer will readily be cut in accordance with the shape of the solar cell module, thus leading to excellent processability.

Further, in the solar cell module of the present invention, a value obtained by subtracting Tg1 from Tmf, and a value obtained by subtracting Tg2 from Tmf, are both 80°C or higher, preferably 90°C or higher, particularly preferably 100°C or higher, where Tmf (°C) is the melting point of the fluororesin, Tg1 (°C) is the glass transition temperature of the crosslinked product of the first resin, and Tg2 (°C) is the glass transition temperature of the crosslinked product of the second resin.

Further, in view of favorable processability and excellent appearance after processing, it is preferred that Tmf is 170°C or higher, and Tg1 and Tg2 are 120°C or lower (preferably 100°C or lower).

The solar cell module of the present invention is preferably a solar cell module obtained by the above method for producing a solar cell module.

The constitution of the solar cell module of the present invention is the same as the constitution of the solar cell module obtained by the above method for producing a solar cell module, and its description is omitted.

Fig. 4 is a schematic plan view illustrating an example of a solar cell array constituted by the solar cell modules of the present invention.

As shown in Fig. 4, a solar cell array 20 is constituted by arranging a plurality of rectangular solar cell modules 10 in a plane and connecting them in series and in parallel.

As specific examples of locations where the solar cell array is to be installed, rooftops, roofs and exterior walls (for example, wall surfaces and windows) of buildings may be mentioned.

The solar cell array having the solar cell modules of the present invention is used preferably for building exterior wall materials (for example, wall surfaces and windows of buildings).

Fig. 4 illustrates an embodiment in which the solar cell array is rectangular, however, the shape of the solar cell array is not particularly limited.

The building exterior wall material of the present invention has the solar cell module of the present invention. As specific examples of the building exterior wall material, curtain walls, wall materials and windows may be mentioned.

### EXAMPLES

Now, the present invention will be described in further detail with reference to Examples. However, it should be understood that the present invention is by no means restricted to such specific Examples. Ex. 1 to 10, 13, 15 and 16 are Examples of the present invention, and Ex. 11, 12 and 14 are Comparative Examples.

### <Encapsulant materials E1 to E4>

E1: a film containing an ultraviolet absorber (hereinafter sometimes referred to as UVA) and an ethylene/vinyl acetate copolymer (hereinafter sometimes referred to as EVA) (manufactured by STR Holdings Inc., PHOTOCAP 15585P HL, melting point: 70°C, thickness: 400 µm, surface free energy: 40 dyn/cm)
E2: a film formed by drawing the film E1 into a thickness of 40 µm by a hot roll pressing machine.
E3: a film formed by drawing the film E1 into a thickness of 100 µm by a hot roll pressing machine.
E4: a film containing a polyvinyl butyral resin (manufactured by Sigma-Aldrich, 182567, melting point: 130°C, thickness: 400 µm, surface free energy: 40 dyn/cm)

### <Design materials D1 to D4>

D1: a film obtained by kneading 100 g of an ethylene/tetrafluoroethylene copolymer (hereinafter sometimes referred to as ETFE) (manufactured by Sigma-Aldrich, product number 427209, melting point: 270°C) and 20 g of titanium oxide (manufactured by SAKAI CHEMICAL INDUSTRY CO., LTD., STR-100A-LP) by Labo Plastomill manufactured by Toyo Seiki Seisaku-sho, Ltd., drawing the kneaded product by a hot roll pressing machine, and applying plasma treatment (thickness: 300 µm, surface free energy: 50 dyn/cm)
D2: a film formed in the same manner as for D1 except that the thickness was 150 µm.
D3: a film formed in the same manner as for D1 except that the thickness was 50 µm.
D4: a film formed in the same manner as for D1 except that the thickness was 20 µm.
D5: a film formed in the same manner as for D1 except that polychlorotrifluoroethylene (hereinafter sometimes referred to as PCTFE) (manufactured by Sigma-Aldrich, product number 454710, melting point: 210°C, Tg:103°C) was used instead of ETFE, and that the thickness was 150 µm.
D6: a film formed in the same manner as for D1 except that a tetrafluoroethylene/hexafluoropropylene copolymer (hereinafter sometimes referred to as FEP) (manufactured by DAIKIN INDUSTRIES, LTD., product number NP-120, melting point: 260°C) was used instead of ETFE, and that the thickness was 150 µm.
D7: a film formed in the same manner as for D1 except that an ethylene/chlorotrifluoroethylene copolymer (hereinafter sometimes referred to as ECTFE) (manufactured by Solvay, product number Halar 930LC, melting point: 245°C) was used instead of ETFE, and that the thickness was 150 µm.
D8: a film formed in the same manner as for D1 except that a polyvinylidene fluoride (hereinafter sometimes referred to as PVDF) (manufactured by Sigma-Aldrich, product number 427144, melting point: 170°C) was used instead of ETFE, and that the thickness was 150 µm.
D9: a film formed in the same manner as for D1 except that a polymethyl methacrylate (hereinafter sometimes referred to as PMMA) (manufactured by Sigma-Aldrich, product number 182230, melting point: 160°C) was used instead of ETFE, and that the thickness was 150 µm.

The thickness of the encapsulant material and the thickness of the design material were measured by Coolant-Proof Micrometer MDC-25MX manufactured by Mitutoyo Corporation.

### (Ex. 1)

One sheet of a back glass having a black layer (manufactured by AGC Inc., Lacobel-T, DEEP BLACK, size: 297 mm x 210 mm, thickness: 5 mm), two sheets of E1 as the third encapsulant layer, one sheet of a crystalline silicon solar cell (monocrystalline, single sided, 5BB-PERC manufactured by NSP), one sheet of E1 as the second encapsulant material, one sheet of D1 as the design material, one sheet of E1 as the first encapsulant material and a soda lime tempered glass plate (thickness: 2.8 mm, Fe₂O₃ content: 0.1 mass%) as the cover glass were overlaid in this order and contact-bonded with heating under a pressure of 700 bar at a temperature of 150°C for 18 minutes to obtain a solar cell module M1. The obtained M1 was evaluated as described hereinafter.

### (Ex. 2 to 16)

Solar cell modules M2 to M16 were obtained in the same manner as in Ex. 1 except that the constitution of the first encapsulant material, the design material and the second encapsulant material was changed as identified in Table 1 and that the heating temperature at the time of contact-bonding with heating was changed as identified in Table 1, and evaluated as described hereinafter.

### <Evaluation method>

### (Processability)

The appearance of the solar cell module was visually observed, and processability at the time of formation into a module was evaluated based on the following standards. The results are shown in Table 1.
A: No wrinkles, distortion nor breakage confirmed on the design layer.
B: Wrinkles or distortion confirmed on the design layer, but no breakage confirmed.
C: Wrinkles or distortion , and breakage, confirmed on the design layer.

### [Table 1]

**[TABLE 1]**

| Ex. | Solar cell module | First encapsulant material (first encapsulant layer) | | | | Design material (design layer) | | | | Second encapsulant material (second encapsulant layer) | | | | Heating temperature (°C) | Processability |
|---|---|---|---|---|---|---|---|---|---|---|---|---|---|---|---|
| | | Type | | Melting point (°C) | Thickness (µm) | Type | | Melting point (°C) | Thickness (µm) | Type | | Melting point (°C) | Thickness (µm) | | |
| 1 | M1 | E1 | EVA | 70 | 400 | D1 | ETFE | 270 | 300 | E1 | EVA | 70 | 400 | 150 | A |
| 2 | M2 | E1 | EVA | 70 | 400 | D2 | ETFE | 270 | 150 | E1 | EVA | 70 | 400 | 150 | A |
| 3 | M3 | E1 | EVA | 70 | 400 | D3 | ETFE | 270 | 50 | E1 | EVA | 70 | 400 | 150 | A |
| 4 | M4 | E1 | EVA | 70 | 400 | D4 | ETFE | 270 | 20 | E1 | EVA | 70 | 400 | 150 | B |
| 5 | M5 | E1 | EVA | 70 | 800 | D1 | ETFE | 270 | 300 | E1 | EVA | 70 | 800 | 150 | A |
| 6 | M6 | E1 | EVA | 70 | 400 | D2 | ETFE | 270 | 150 | E1 | EVA | 70 | 400 | 170 | A |
| 7 | M7 | E1 | EVA | 70 | 400 | D5 | PCTFE | 210 | 150 | E1 | EVA | 70 | 400 | 150 | A |
| 8 | M8 | E1 | EVA | 70 | 400 | D6 | FEP | 260 | 150 | E1 | EVA | 70 | 400 | 150 | A |
| 9 | M9 | E1 | EVA | 70 | 400 | D7 | ECTFE | 245 | 150 | E1 | EVA | 70 | 400 | 150 | A |
| 10 | M10 | E1 | EVA | 70 | 400 | D8 | PVDF | 170 | 150 | E1 | EVA | 70 | 400 | 170 | B |
| 11 | M11 | E1 | EVA | 70 | 400 | D9 | PMMA | 160 | 150 | E1 | EVA | 70 | 400 | 170 | C |
| 12 | M12 | E2 | EVA | 70 | 40 | D2 | ETFE | 270 | 150 | E1 | EVA | 70 | 400 | 150 | C |
| 13 | M13 | E3 | EVA | 70 | 100 | D2 | ETFE | 270 | 150 | E1 | EVA | 70 | 400 | 150 | B |
| 14 | M14 | E1 | EVA | 70 | 400 | D2 | ETFE | 270 | 150 | E2 | EVA | 70 | 40 | 150 | C |
| 15 | M15 | E1 | EVA | 70 | 400 | D2 | ETFE | 270 | 150 | E3 | EVA | 70 | 100 | 150 | B |
| 16 | M16 | E4 | PVB | 140 | 400 | D2 | ETFE | 270 | 150 | E4 | PVB | 140 | 400 | 150 | A |

The solar cell modules M1 to M5, obtained by using EVA having a thickness of from 400 to 800 µm as the first encapsulant material and the second encapsulant material and ETFE having a thickness of from 20 to 300 µm as the design material, at a contact-bonding temperature of 150°C, had favorable appearance. On the solar cell module M4 in which the design layer had a thickness of 20 µm, the solar cell module M13 in which the first encapsulant layer had a thickness of 100 µm, and the solar cell module M15 in which the second encapsulant layer had a thickness of 100 µm, minute distortion of the design layer was confirmed. Whereas on the solar cell modules M12 and M14 in which the first encapsulant layer or the second encapsulant layer had a thickness less than 50 µm, remarkable wrinkles and distortion and minute breakage of the design layer were confirmed, and particularly on the solar cell module M14, discoloration due to elongation of the design layer was confirmed. Further, the solar cell module M6 obtained by using the same members as that of M2 at a contact-bonding temperature of 170°C also had favorable appearance.

The solar cell module M2 obtained by using ETFE, and the solar cell modules M7 to M9 obtained by using PCTFE, FEP and ECTFE respectively, as the design material, had favorable appearance, since the melting point of the resin in the design material was sufficiently higher than the heating temperature at the time of contact-bonding. Whereas on the solar cell module M10 obtained by using PVDF as the design material at a contact-bonding temperature at the same level as the melting point of PVDF, minute wrinkles and distortion were confirmed. Further, on the solar cell module M11 obtained by using PMMA as the design material at a contact-bonding temperature higher than the melting point of PMMA, remarkable wrinkles and distortion and minute breakage of the design layer were confirmed, and discoloration due to distortion of the design layer was confirmed.

### REFERENCE SYMBOLS

10, 100: solar cell module
11, 110A, 110B: cover glass
12, 120A, 120B: first encapsulant layer
13, 130A, 130B: design layer
14, 140A, 140B: second encapsulant layer
15, 150: solar cell
15A, 150A: first light-receiving surface
16: third encapsulant layer
17: back glass
20: solar cell array
150B: second light-receiving surface

The entire disclosure of Japanese Patent Application No. 2019-212142 filed on November 25, 2019 including specification, claims, drawings and summary is incorporated herein by reference in its entirety.

## Claims

1. A method for producing a solar cell module, which comprises disposing a cover glass, a first encapsulant material containing a first resin, a design material containing a fluororesin, a second encapsulant material containing a second resin and solar cells in this order, and contact-bonding them with heating to produce a solar cell module,
wherein the solar cell module comprises, from the light-receiving surface side of the solar cell module,
the cover glass,
a first encapsulant layer having a thickness of from 50 to 2,000 µm, formed of the first encapsulant material,
a design layer having a thickness of from 10 to 1,000 µm, formed of the design material,
a second encapsulant layer having a thickness of from 50 to 2,000 µm, formed of the second encapsulant material, and
the solar cells in this order,
and wherein a value obtained by subtracting Tm1 from Tmf, and a value obtained by subtracting Tm2 from Tmf, are both 30°C or higher, where Tmf (°C) is the melting point of the fluororesin, Tm1 (°C) is the melting point of the first resin, and Tm2 (°C) is the melting point of the second resin.

2. The method for producing a solar cell module according to Claim 1, wherein at least one of the first resin and the second resin contains at least one member selected from the group consisting of an ethylene/vinyl acetate copolymer and a polyvinyl butyral resin.

3. The method for producing a solar cell module according to Claim 1 or 2, wherein the fluororesin contains at least one member selected from the group consisting of an ethylene/tetrafluoroethylene copolymer, an ethylene/chlorotrifluoroethylene copolymer, a polychlorotrifluoroethylene, a tetrafluoroethylene/hexafluoropropylene copolymer and a polyvinylidene fluoride.

4. The method for producing a solar cell module according to any one of Claims 1 to 3, wherein the heating temperature at the time of contact-bonding with heating is Tmf or lower and is higher than Tm1 and Tm2.

5. The method for producing a solar cell module according to any one of Claims 1 to 4, wherein the solar cells are silicone solar cells constituted by monocrystalline silicon or polycrystalline silicon, or compound solar cells constituted by CIS or CIGS.

6. The method for producing a solar cell module according to any one of Claims 1 to 5, wherein Tmf is 170°C or higher, and Tm1 and Tm2 are 200°C or lower.

7. The method for producing a solar cell module according to any one of Claims 1 to 6, wherein the first resin is crosslinked, and the second resin is crosslinked.

8. The method for producing a solar cell module according to any one of Claims 1 to 7, wherein the thickness of the design layer is from 0.1 to 0.9 times the thickness of the first encapsulant layer, and/or the thickness of the design layer is from 0.1 to 0.9 times the thickness of the second encapsulant layer.

9. A solar cell module, which comprises, from the light-receiving surface side of the solar cell module, a cover glass, a first encapsulant layer containing a first resin and having a thickness of from 50 to 2,000 µm, a design layer containing a fluororesin and having a thickness of from 10 to 1,000 µm, a second encapsulant layer containing a second resin and having a thickness of from 50 to 2,000 µm, and solar cells in this order,
wherein a value obtained by subtracting Tm1 from Tmf, and a value obtained by subtracting Tm2 from Tmf, are both 30°C or higher, where Tmf (°C) is the melting point of the fluororesin, Tm1 (°C) is the melting point of the first resin, and Tm2 (°C) is the melting point of the second resin.

10. The solar cell module according to Claim 9, wherein Tmf is 170°C or higher, and Tm1 and Tm2 are 200°C or lower.

11. A solar cell module, which comprises, from the light-receiving surface side of the solar cell module, a cover glass, a first encapsulant layer containing a crosslinked product of a first resin and having a thickness of from 50 to 2,000 µm, a design layer containing a fluororesin and having a thickness of from 10 to 1,000 µm, a second encapsulant layer containing a crosslinked product of a second resin and having a thickness of from 50 to 2,000 µm, and solar cells in this order,
wherein a value obtained by subtracting Tg1 from Tmf, and a value obtained by subtracting Tg2 from Tmf, are both 80°C or higher, where Tmf (°C) is the melting point of the fluororesin, Tg1 (°C) is the glass transition temperature of the crosslinked product of the first resin, and Tg2 (°C) is the glass transition temperature of the crosslinked product of the second resin.

12. The solar cell module according to Claim 11, wherein Tmf is 170°C or higher, and Tg1 and Tg2 are 120°C or lower.

13. The solar cell module according to any one of Claims 9 to 12, wherein at least one of the first resin and the second resin contains at least one member selected from the group consisting of an ethylene/vinyl acetate copolymer and a polyvinyl butyral resin.

14. The solar cell module according to any one of Claims 9 to 13, wherein the fluororesin contains at least one member selected from the group consisting of an ethylene/tetrafluoroethylene copolymer, an ethylene/chlorotrifluoroethylene copolymer, a polychlorotrifluoroethylene, a tetrafluoroethylene/hexafluoropropylene copolymer and a polyvinylidene fluoride.

15. A building exterior wall material having the solar cell module as defined in any one of Claims 9 to 14.
